# EUROPÄISCHE PATENTSCHRIFT

(11) **EP 2 217 938 B1**
(45) Veröffentlichungstag und Bekanntmachung des Hinweises auf die Patenterteilung: **17.05.2017**
(21) Anmeldenummer: 08855880.4
(22) Anmeldetag: 05.12.2008
(51) Int. Cl.: G01R 31/34

(54) **VERFAHREN ZUR ÜBERWACHUNG DES WELLENSTROMES UND/ODER DER ISOLATION DER WELLE VON ELEKTROMASCHINEN**
METHOD FOR MONITORING THE SHAFT CURRENT AND/OR THE INSULATION OF THE SHAFT OF ELECTRIC MACHINES
PROCÉDÉ DE SURVEILLANCE DU COURANT D'ARBRE ET/OU DE L'ISOLATION DE L'ARBRE DE MACHINES ÉLECTRIQUES

(30) Priorität: 07.12.2007 CH 18952007
(43) Veröffentlichungstag der Anmeldung: 18.08.2010
(73) Patentinhaber: General Electric Technology GmbH, 5400 Baden (CH)
(72) Erfinder: HOBELSBERGER, Max, CH-5303 Würenlingen (CH); POSEDEL, Zlatimir, CH-5432 Neuenhof (CH)
(74) Vertreter: General Electric Technology GmbH
(86) Internationale Anmeldenummer: PCT/EP2008/066872
(87) Internationale Veröffentlichungsnummer: WO 2009/071656

(56) Entgegenhaltungen:
- EP-A- 0 391 181
- WO-A-97/30359
- WO-A-2004/025316
- WO-A-2006/134068
- US-A- 3 831 160
- US-A- 4 147 982
- COSTELLO M J: "Shaft voltages and rotating machinery" PETROLEUM AND CHEMICAL INDUSTRY CONFERENCE, 1991, RECORD OF CONFERENCE PAPERS., INDUSTRY APPLICATIONS SOCIETY 38TH ANNUAL TORONTO, ONT., CANADA 9-11 SEPT. 1991, NEW YORK, NY, USA,IEEE, US, 9. September 1991 (1991-09-09), Seiten 71-78, XP010053131 ISBN: 0-7803-0193-5
- RAYMOND ONG ET AL: "A COMPARISON OF TECHNIQUES FOR MEASUREMENT OF SHAFT CURRENTS IN ROTATING MACHINES" IEEE TRANSACTIONS ON ENERGY CONVERSION, IEEE SERVICE CENTER, PISCATAWAY, NJ, US, Bd. 12, Nr. 4, Dezember 1997 (1997-12), Seiten 363-367, XP011015503 ISSN: 0885-8969
- SCHIFERL R F ET AL: "Inverter driven induction motor bearing current solutions" INDUSTRY APPLICATIONS SOCIETY 49TH ANNUAL PETROLEUM AND CHEMICAL INDUSTRY CONFERENCE. ( PCIC ). RECORD OF CONFERENCE PAPERS. NEW ORLEANS, LA, SEPT. 23 - 25, 2002, INDUSTRY APPLICATIONS SOCIETY ANNUAL PETROLEUM AND CHEMICAL INDUSTRY CONFERENCE, NEW YO, Bd. CONF. 49, 23. September 2002 (2002-09-23), Seiten 67-75, XP010611378 ISBN: 0-7803-7384-7

## Beschreibung

### Technisches Gebiet

Die vorliegende Erfindung bezieht sich auf das Gebiet der elektrischen Maschinen. Sie betrifft ein Verfahren zur Überwachung des Wellenstromes und/oder der Isolation der Welle von elektrodynamischen Maschinen während des Betriebs.

### Stand der Technik

Während des Betriebes von elektrodynamischen Maschinen wie z.B. Grossen Generatoren oder Motoren treten elektrische Spannungen zwischen Welle und Gehäuse oder Erde auf. Üblicherweise ist die Welle an einer Seite der Maschine geerdet. An der anderen Seite der Maschine muss deshalb die Welle auf Grund der auftretenden Spannungen von Erde isoliert sein. Dazu werden z.B. isolierte Lager eingesetzt.

Falls diese Isolation wegen Bauteilfehlern etc. elektrisch leitend überbrückt wird, fliessen in der Welle elektrische Ströme, welche die Welle und angrenzende Bauteile wie z.B. die Lager beschädigen können.

Es besteht deshalb das Bedürfnis, das Auftreten von solchen Isolationsfehlern bzw. Strömen zu detektieren, um dann durch geeignete Massnahmen die Maschine vor weitergehenden Schäden zu schützen.

Aus dem Stand der Technik ist bekannt (siehe z.B. die Druckschrift US-A-6,300,701), den Wellenstrom mittels einer um die Welle herum angeordneten Rogowski-Spule zu messen und auf einen vorgegebenen Maximalwert zu überwachen. Ein Überschreiten dieses vorgegebenen Wertes löst eine entsprechende Warnmeldung aus.Darüber hinaus zeigt WO2006/134068 A1 eine Anordnung und ein Verfahren zur Lagerstromüberwachung eines Elektromotors. Ähnliche Lösungen mit Induktionsspulen werden in den kommerziell erhältlichen Geräten (z.B. das System "RARIC" der Firma ABB oder das System "DRS-Compact2A" der Firma VA Tech SAT) benützt.

Nachteilig bei den oben genannten Verfahren und Vorrichtungen ist, dass die Induktionsspulen oder Rogowski-Spulen nicht ideal arbeiten und auch Signale erzeugen, die nicht vom Strom durch die Welle stammen, sondern von anderen Feldern induziert werden. Typischerweise erzeugt das Streufeld des magnetischen Hauptfeldes der Maschine ein solches Störsignal.

Um Messfehler durch Streufelder zu vermeiden, kann das o.g. Gerät "RARIC" so eingestellt werden, dass durch geeignete Filterung nur die dritte Netz-Harmonische des aufgenommenen Signals ausgewertet wird. Die Netzharmonischen sind dabei die Signalanteile, deren Frequenzen ein ganzzahliges Vielfaches der Netzgrundfrequenz sind. Dabei wird davon ausgegangen, dass die störenden Felder dominant nur die Grundharmonische aufweisen. Die Grösse dieser dritten Harmonischen wird einer Grenzwertbewertung unterworfen.

Es zeigt sich jedoch in der Praxis, dass die Messung trotz Filterung noch recht störanfällig ist. Das bedeutet, dass die Grenzwerte relativ hoch gesetzt werden müssen, um Fehlalarme zu vermeiden. Um Lagerschäden zu vermeiden, sollten jedoch schon kleine Ströme in der Welle sicher detektiert werden können.

### Darstellung der Erfindung

Es ist Aufgabe der Erfindung, ein Verfahren anzugeben, bei denen die Störempfindlichkeit der Wellenstrommessung mit Induktions- bzw. Rogowski-Spulen deutlich verringert ist, und die eine zuverlässigere und somit auch empfindlichere Messung der Wellenströme mit Induktionsspulen ermöglichen.

Die Aufgabe wird durch den Gegenstand des Anspruchs 1 gelöst. Wesentlich für die Erfindung ist, dass die Wellenspannung und der zugehörige Wellenstrom an der Welle gemessen werden, dass aus den Messergebnissen für die Wellenspannung und den Wellenstrom für die elektrodynamische Maschine eine Beziehung zwischen der Wellenspannung und dem zugehörigen Wellenstrom ermittelt wird, und dass zur Überwachung des Wellenstromes der elektrodynamischen Maschine die Wellenspannung überwacht und aus der überwachten Wellenspannung aufgrund der ermittelten Beziehung zwischen der Wellenspannung und dem zugehörigen Wellenstrom auf den zu überwachenden Wellenstrom geschlossen wird.

Der Wellenstrom wird dabei vorzugsweise induktiv an der Welle gemessen, und zwar mittels einer um die Welle herum angeordneten Rogowski-Spule.

Eine Ausgestaltung des erfindungsgemässen Verfahrens ist dadurch gekennzeichnet, dass die Frequenzspektren der Wellenspannung und des zugehörigen Wellenstroms gemessen werden, und dass als Beziehung zwischen der Wellenspannung und dem zugehörigen Wellenstrom eine als Impedanzfunktion des Wellenkontaktkreises interpretierbare Transferfunktion Z_{W}(jω) = U_{W}(jω)/I_{W}(jω) ermittelt wird, welche den Zusammenhang zwischen den Spektren der Wellenspannung und des zugehörigen Wellenstroms im Frequenzbereich beschreibt.

Insbesondere kann zur vereinfachten Ermittlung der Transferfunktion die Struktur eines resistiv-induktiven Tiefpasses 1. Ordnung zugrunde gelegt werden.

Noch einfacher ist es, wenn als Transferfunktion ein frequenzunabhängiger Proportionalitätsfaktor bestimmt wird, der den Zusammenhang zwischen den Spektren der Wellenspannung und des zugehörigen Wellenstroms im unteren Frequenzbereich der elektrodynamischen Maschine beschreibt.

Eine Weiterbildung dieses Verfahrens zeichnet sich dadurch aus, dass mittels des Proportionalitätsfaktors aus der gemessenen Wellenspannung ein geschätzter Wellenstrom berechnet wird, dass der Effektivwert des so berechneten Wellenstromes bestimmt wird, und dass der bestimmte Effektivwert im Zuge der Überwachung des Wellenstromes einer Bewertung mittels vorgegebener Grenzwerte unterworfen wird.

Es kann aber auch im Zuge der Überwachung des Wellenstromes der Proportionalitätsfaktor direkt einer Bewertung mittels vorgegebener Grenzwerte unterworfen werden.

Eine andere Ausgestaltung der Erfindung ist dadurch gekennzeichnet, dass zur Bestimmung des Proportionalitätsfaktors die einzelnen Proportionalitätsfaktoren der ungradzahligen Harmonischen einer Grundfrequenz, insbesondere Netzfrequenz, der Wellenspannung und des Wellenstromes durch Division von Amplituden gleicher Ordnungszahl nach Massgabe der Gleichung Z_{W}(nω) = U_{W}(nω))/I_{W}(nω) bestimmt werden, und dass aus der Menge der einzelnen Proportionalitätsfaktoren durch Medianbildung oder Mittelwertbildung ein resultierender geschätzter Proportionalitätsfaktor gewonnen wird.

Vorzugsweise werden die einzelnen Proportionalitätsfaktoren bis zu einer vorgegebenen oberen Grenzfrequenz, insbesondere etwa 1000 Hz, bestimmt.

Eine andere Ausgestaltung der Erfindung ist dadurch gekennzeichnet, dass die Phasenwinkel Φ_{Z} = Φ_{U}(nω)-Φ_{I}(nω) der einzelnen Proportionalitätsfaktoren ermittelt werden, und dass die Proportionalitätsfaktoren mit Phasenwinkeln, die von den nach einer einfachen Transferfunktion zu erwartenden Werten stark abweichen, vor der Medianbildung bzw. Mittelwertbildung ausgeschieden werden.

Eine weitere Ausgestaltung der Erfindung ist dadurch gekennzeichnet, dass zu einem Zeitpunkt, zu dem bekannt ist, dass die Welle so isoliert ist, dass keine Wellenströme fliessen, die Signale einer für die Wellenstrommessung vorgesehenen Messspule bzw. Rogowski-Spule aufgenommen werden, dass mittels einer Spektralanalyse Spektrallinien ermittelt werden, die von störenden Feldern eingekoppelt werden, und dass die zu Frequenzen mit dominanten Stör-Amplitudenwerten gehörenden einzelnen Proportionalitätsfaktoren vor einer Medianbildung aus der Menge der einzelnen Proportionalitätsfaktoren ausgeschieden werden.

Eine andere Ausgestaltung der Erfindung zeichnet sich dadurch aus, dass Spektren der Wellenspannung bei verschiedenen Lastzuständen der elektrodynamischen Maschine nur einmal, z.B. bei Inbetriebnahme eines Überwachungssystems, störungsfrei gemessen und die Werte abgespeichert werden, dass im Betrieb der elektrodynamischen Maschine bestimmt wird, in welchem Lastzustand sich die elektrodynamische Maschine momentan befindet, und dass dann ein diesem Lastzustand entsprechender Datensatz mit dem jeweils gültigen Spektrum aus einem internen Speicher ausgelesen wird.

### Kurze Erläuterung der Figuren

Die Erfindung soll nachfolgend anhand von Ausführungsbeispielen im Zusammenhang mit der Zeichnung näher erläutert werden. Es zeigen
- Fig. 1: ein beispielhaftes, gemessenes Frequenzspektrum einer Wellenspannung U_{W}, wobei die Teilung der Frequenzachse 200 Hz beträgt;
- Fig. 2: das zu Fig. 1 gehörende gemessene Frequenzspektrum des Wellenstromes I_{W}; und
- Fig. 3: ein stark vereinfachtes Schema einer Überwachungsvorrichtung gemäss der Erfindung.

### Wege zur Ausführung der Erfindung

Bei der vorliegenden Erfindung wird eine verbesserte Überwachung des Wellenstromes bzw. der Isolation prinzipiell dadurch ereicht, dass das gemessene, den Wellenstrom charakterisierende Signal anhand des Spektrums der Wellenspannung beurteilt wird.

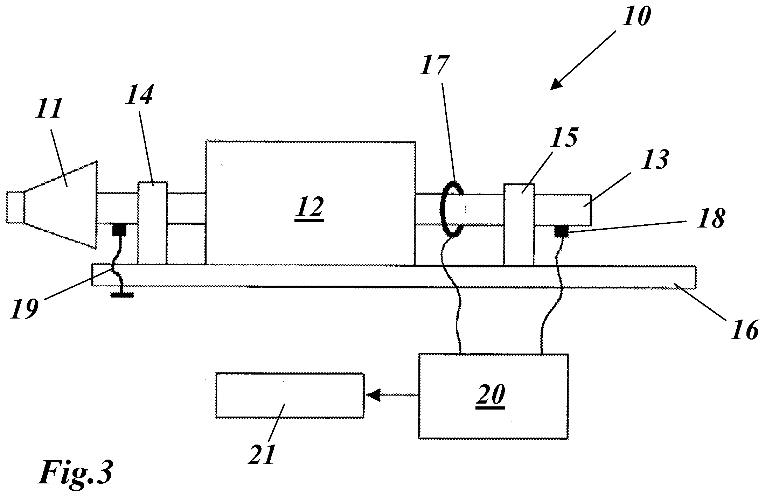

Ein typischer Aufbau der zugrunde liegenden Anordnung ist in Fig. 3 dargestellt: Ein Generator 12 zur Erzeugung elektrischer Energie ist mit seiner Welle 13 an die Turbine 11 einer Gasturbinen- oder Dampfturbinenanlage angekoppelt. Die Welle 13 ist an ihren beiden Enden in entsprechenden Lagern 14 und 15 gelagert, die sowohl das Gewicht des Rotors als auch axiale Schubkräfte aufnehmen. Die gesamte Anordnung ruht auf einer Grundplatte 16. Am einen Ende (in Fig. 3 links) ist die Welle 18 über eine Erdung 19 geerdet. Am anderen Ende ist die Welle isoliert gelagert, um Wellenströme zu vermeiden. Zur Überwachung dieser Isolation bzw. der Wellenströme sind eine um die Welle 13 herum gelegte Rogowski-Spule 17 (zur Aufnahme der mit Wellenströmen verbundenen Magnetfelder) und eine Messbürste 18 zur Abnahme der Wellenspannung vorgesehen.

Grundlage des vorliegenden Verfahrens ist die Erkenntnis, dass die primäre Ursache eines möglichen Wellenstromes die Wellenspannung ist, die in der Schleife zwischen Welle und Gehäuse bzw. Erde induziert wird. Weiters ist bekannt, dass jede Maschine eine für sie typische Wellenspannung aufweist, die eine nur bei der jeweiligen Maschine vorkommende spektrale Struktur aufweist, die nur vom leistungsmässigen Betriebspunkt der Maschine abhängt, also z.B. keine zeitliche Änderungen zeigt. Weitere Grundlage ist, dass diese Wellenspannung weitgehend störungsfrei ermittelt werden kann.

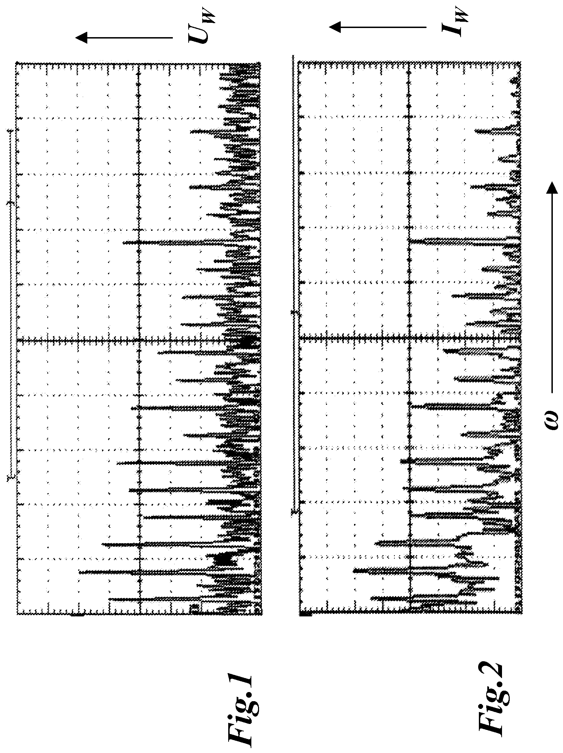

Eine weitere Grundlage ist die Erkenntnis, dass der Stromkreis, in dem der Wellenstrom fliesst, im unteren Frequenzbereich weitgehend resistiv, und darüber resistiv-induktiv als Tiefpass wirkt. Dies hat sich bei Messungen bestätigt: Es hat sich insbesondere gezeigt, dass das Spektrum des Wellenstromes im unteren Frequenzbereich (bis ca. 500 Hz) mit einem annähernd konstanten Faktor dem Spektrum der in diesem Lastpunkt induzierten Wellenspannung proportional ist (siehe die beiden Fig. 1 und 2). Dieser Proportionalitätsfaktor kann als Impedanz der Kontaktstelle, Kontaktschleife oder Gesamtschleife interpretiert werden.

Das Grundprinzip der neuen Methode ist nun, diese Beziehung zwischen Wellenspannung und gemessenem Wellenstrom zu ermitteln. Aufgrund der gefundenen Beziehung kann dann aus dem meist weniger gestörten Messergebnis der Wellenspannungsmessung auf den Wellenstrom geschlossen werden.

In einer bevorzugten Ausführung werden sowohl das Bild der Wellenspannung als auch das von der Messspule stammende Messsignal mittels Fouriertransformation oder mittels mehrfacher Bandpassfilter einer Frequenzanalyse unterzogen und die zugehörigen Spektren ermittelt.

Die Grundfrequenz der harmonischen Analyse beider Spannungen ist dabei vorzugsweise die Grundfrequenz der Netzspannung oder die Drehfrequenz des Rotors oder ganzzahlige Vielfache bzw. Teiler davon. Es kann aber auch ein annähernd kontinuierliches Spektrum mit kleinem Linienabstand ermittelt werden. Vorzugsweise werden die Amplituden- und Phasenspektren ermittelt.

Durch geeignete Filterung und Schätzung kann dann eine Transferfunktion gefunden werden, die den Zusammenhang zwischen den Spektren der Wellenspannung und des Wellenstromes im Frequenzbereich beschreibt. Diese Transferfunktion gibt bekanntlich das Amplitudenverhältnis und die Phasenverwerfung zwischen Wellenspannung und Wellenstrom, Z_{W}(jω) = U_{W}(jω)/I_{W}(jω), an und kann als Impedanzfunktion des Wellenkontakt-Kreises interpretiert werden.

Zur Schätzung dieser Transferfunktion ist es hilfreich, physikalisch naheliegende, mögliche und einfache Impedanzstrukturen zu verwenden. In einer bevorzugten Ausführung wird die Struktur eines resistiv-induktiven Tiefpasses 1. Ordnung gewählt.

Die Erkenntnis, dass das Spektrum der Wellenspannung dominante Amplitudenwerte nur im unteren Frequenzbereich aufweist, der meist unterhalb der Grenzfrequenz des Tiefpasses liegt, erlaubt eine weitere Vereinfachung: Die Aufgabe reduziert sich in einer bevorzugten Ausführung auf das Abschätzen eines einzigen, frequenzunabhängigen Proportionalitätsfaktors, der den Zusammenhang zwischen Wellenspannungsspektrum und Wellenstromspektrum im unteren Frequenzbereich beschreibt.

Dieser Proportionalitätsfaktor erlaubt es, aus der meist mit nur geringen Störungen aufgenommenen Wellenspannung einen geschätzten Wellenstrom zu berechnen. Der Effektivwert des geschätzten Wellenstromes wird dann einer Bewertung mittels Grenzwerten unterworfen. Der Effektivwert des Gesamtstromes ergibt sich dabei wie üblich durch Wurzelziehen aus der Summe der Quadrate der Amplituden der einzelnen Strom-Harmonischen.

Vorteilhafterweise kann aber auch direkt der Proportionalitätsfaktor, d.h. der Kontaktwiderstand oder Isolationswiderstand, einer Bewertung unterzogen. Sobald ein Grenzwert des Isolationswiderstandes unterschritten wird, wird eine Warnung ausgegeben.

Zur Ermittlung des geschätzten Proportionalitätswertes werden beispielsweise die einzelnen Proportionalitätsfaktoren der ungradzahligen Netzharmonischen der Wellenspannung und des Wellenstromes bis zu einer Frequenz von ca. 1000 Hz durch Division von Amplituden gleicher Ordnungszahl gewonnen: Z_{W}(nω) = U_{W}(nω)/I_{W}(nω). Aus der Menge der gewonnenen Einzelfaktoren {Z_{W}(nω)} wird dann durch z.B. Medianbildung oder auch Mittelwertsbildung ein resultierender, geschätzter Faktor gewonnen. Durch die Medianbildung werden Messergebnisse aus Frequenzbereichen, in denen das Störsignal bei der Strommessung verstärkt auftritt, ergebnismässig ausgeblendet.

Es können weiters auch die Phasenwinkel Φ_{Z} = Φ_{U}(nω)-Φ_{I}(nω) der einzelnen Impedanzwerte ermittelt und zur Störungsunterdrückung benützt werden. Es ist ja eine einfache Impedanzfunktion, z.B. eines Tiefpasses erster Ordnung, zu erwarten. Impedanzwerte mit Phasenwinkeln, die von den dieser Funktion entsprechenden Erwartungswerten stark abweichen, können ausgeschieden werden. Danach wird, wie oben beschrieben, die Medianbildung durchgeführt.

Ausserdem können zu einem Zeitpunkt, zu dem bekannt ist, dass die Welle so isoliert ist, dass keine Wellenströme fliessen, die Signale der Messspule aufgenommen werden. Eine Spektralanalyse ergibt dann Spektrallinien, die offensichtlich von störenden Feldern eingekoppelt werden. Die zu Frequenzen mit dominanten Stör-Amplitudenwerten gehörenden Impedanzwerte werden dann aus der Menge der Impedanzwerte ausgeschieden. Danach wird, wie oben beschrieben, die Medianbildung durchgeführt.

Bei der Ermittlung des Spektrums der Wellenspannung ist zu beachten, dass das Spektrum der induzierten Wellenspannung nur vom jeweiligen Lastpunkt, primär vom Wirklastpunkt, der Maschine abhängt, und dass das Spektrum im oberen Lastbereich sogar ziemlich konstant bleibt. Weiters ist bekannt, dass die Quellenimpedanz der Spannungsquelle im Wellenspannungskreis relativ niedrig ist, so dass bis zu relativ grossen Wellenströmen nur ein geringer Spannungsabfall auftritt.

Aus diesen Erkenntnissen ergibt sich die Möglichkeit, die Spektren der Wellenspannung bei verschiedenen Lastzuständen nur einmal, z.B. bei Inbetriebnahme des Überwachungssystems, optimal, d.h. störungsfrei, zu messen und die Werte abzuspeichern. Im Betrieb muss dann dem Überwachungssystem nur übermittelt werden, in welchem Lastzustand sich die Maschine momentan befindet. Das Überwachungssystem kann dann einen diesem Lastzustand entsprechenden Datensatz mit dem jeweils gültigen Spektrum aus einem internen Speicher auslesen.

Aufgrund der geringen Varianz der Spektren kann auch eine nur geringe Anzahl von den verschiedenen Lastzuständen entsprechenden Datensätzen abgespeichert werden, z.B. einer für Leerlauf, einer für Halb-Wirklast, einer für Nennwirklast. Im Extremfall wird z.B. nur das Spektrum bei Nennlast abgespeichert. Da die Wellenspannungen bei Leerlauf der Schleife ermittelt wurden, entspricht die ermittelte Impedanz dann der Gesamtimpedanz des Kreises.

Oder es wird die Wellenspannung kontinuierlich und zeitlich parallel zum Wellenstrom mitgemessen. Diese Methode hat den Vorteil, dass die Ergebnisse einer dauernden Messung der Wellenspannung auch für andere Überwachungsaufgaben verwendet werden können, wie Windungsschluss-Detektion, Vibrationsmessungen etc.. Ausserdem wird die eigentliche Kontakt-Schleifenimpedanz ermittelt, da auch der Spannungsabfall über die Quellenimpedanz in die Berechnung eingeht. Nachteilig wirkt sich natürlich der zusätzliche Aufwand für die Messung aus.

Wie bereits oben erwähnt, zeigt Fig. 3 zeigt einen Generator 12 mit Welle 13, Turbine 11 und 2 Lagern 14, 15. Es werden der Wellenstrom mittels einer Rogowski-Spule 17 und die Wellenspannung an der Nicht-Antriebsseite des Generators 12 über die Messbürste (Schleifbürste) 18 gemessen. Die Welle 13 ist an der Antriebsseite des Generators 12 geerdet (Erdung 19). Eine Verarbeitungseinheit 20 berechnet den Wellenstrom und den Isolationswiderstand und sendet zyklisch Messwerte an eine angeschlossene Überwachungseinheit 21, die als Monitoring- und Trending-System arbeitet.

Im Berechnungsbeispiel der nachfolgenden Tabelle sind die dominanten Amplituden der Strom- und Spannungsspektren im Bereich bis 1350 Hz gezeigt. Es wird der Median der Impedanzwerte berechnet und der Effektivwert des geschätzten Stromes.

| **Frequenz** | **gespeicherte Wellenspannung** | **gemessener Wellenstrom** | **berechneter Widerstand** | **geschätzter Strom** | **Stromquadrat** |
|---|---|---|---|---|---|
| 50 | 0,283 | 4,5 | 0,063 | 2,653125 | 7,039072 |
| 150 | 0,894 | 9,7 | 0,092 | 8,38125 | 70,24535 |
| 250 | 0,356 | 3,7 | 0,099 | 3,421875 | 11,70923 |
| 350 | 0,077 | 0,9 | 0,086 | 0,721875 | 0,521104 |
| 450 | 0,128 | 1,2 | 0,107 | 1,2 | 1,44 |
| 550 | 0,208 | 1,3 | 0,160 | 1,95 | 3,8025 |
| 650 | 0,017 | 0,1 | 0,170 | 0,159375 | 0,0254 |
| 750 | 0,119 | 0,8 | 0,149 | 1,115625 | 1,244619 |
| 1350 | 0,157 | 0,9 | 0,174 | 1,471875 | 2,166416 |
| | | | | | |
| | | | | | 98,19369 |
| | | **Median** | **0,107** | **9,909273001** | **A rms** |

Insgesamt zeichnet sich die Erfindung durch die folgenden Merkmale aus:
- Zur Verbesserung der Störungsunterdruckung wird der mittels einer Rogowski-Spule gemessene Wellenstrom anhand der Wellenspannung bewertet und gefiltert.
- Die Bewertung erfolgt im Frequenzbereich mittels der Strom- und Spannungsspektren (Amplituden- und Phasenspektren), wobei die Amplituden und Phasenwinkel der Harmonischen gleicher Ordnungszahl zueinander in Relation gesetzt werden.
- Die Verhältnisse zwischen zugehörigen Spannungs- und Stromamplituden und die entsprechenden Phasendifferenzen werden als Impedanzwerte interpretiert.
- Mittels statistischer Bewertungsverfahren werden aus der Menge der so ermittelten Impedanzwerte diejenigen Werte ausgewählt, die wahrscheinlich die geringste Störbeeinflussung aufweisen.
- In einer bevorzugten Ausführung wird dazu der Median der Amplituden der ermittelten Impedanzwerte ausgewählt.
- In einer weiteren bevorzugten Ausführung werden Frequenzen mit starker Störbeeinflussung im fehlerfreien Maschinenzustand ermittelt und entsprechende Impedanzwerte aus der weiteren Berechnung ausgeschlossen. Aus den verbliebenen Impedanzwerten wird z.B. der Median ausgewählt.
- Der ausgewählte Impedanzwert erlaubt es dann, aus dem Wellenspannungsspektrum durch Multiplikation mit dem Impedanzwert ein geschätztes Wellenstromspektrum zu berechnen. Daraus kann wiederum der Effektivwert des Wellenstromes berechnet werden.
- Sowohl der Impedanzwert als auch der effektive Wellenstrom werden einer Bewertung durch Vergleich mit Grenzwerten unterzogen.
- Vorzugsweise wird die Wellenspannung simultan mitgemessen.

### Bezugszeichenliste

- 10: Kraftwerksanlage
- 11: Turbine
- 12: Generator
- 13: Welle
- 14,15: Lager
- 16: Grundplatte
- 17: Rogowski-Spule
- 18: Messbürste
- 19: Erdung
- 20: Verarbeitungseinheit
- 21: Überwachungseinheit
- U_{W}: Wellenspannung
- I_{W}: Wellenstrom
- ω: Frequenz

## Patentansprüche

1. Verfahren zur Überwachung des Wellenstromes (I_{W}) und/oder der Isolation der Welle (13) von elektrodynamischen Maschinen (12) während des Betriebs, **dadurch gekennzeichnet, dass** die Wellenspannung (U_{W}) und der zugehörige Wellenstrom (I_{W}) an der Welle (13) gemessen werden, dass aus den Messergebnissen für die Wellenspannung (U_{W}) und den Wellenstrom (I_{W}) für die elektrodynamische Maschine (12) eine Beziehung zwischen der Wellenspannung (U_{W}) und dem zugehörigen Wellenstrom (I_{W}) ermittelt wird, und dass zur Überwachung des Wellenstromes (I_{W}) der elektrodynamischen Maschine (12) die Wellenspannung (U_{W}) überwacht und aus der überwachten Wellenspannung (U_{W}) aufgrund der ermittelten Beziehung zwischen der Wellenspannung (U_{W}) und dem zugehörigen Wellenstrom (I_{W}) auf den zu überwachenden Wellenstrom (I_{W}) geschlossen wird.

2. Verfahren nach Anspruch 1, **dadurch gekennzeichnet, dass** der Wellenstrom (I_{W}) induktiv an der Welle (13) gemessen wird.

3. Verfahren nach Anspruch 2, **dadurch gekennzeichnet, dass** der Wellenstrom (I_{W}) mittels einer um die Welle (13) herum angeordneten Rogowski-Spule (17) gemessen wird.

4. Verfahren nach einem der Ansprüche 1 bis 3, **dadurch gekennzeichnet, dass** die Frequenzspektren der Wellenspannung (U_{W}) und des zugehörigen Wellenstroms (I_{W}) gemessen werden, und dass als Beziehung zwischen der Wellenspannung (U_{W}) und dem zugehörigen Wellenstrom (I_{W}) eine als Impedanzfunktion des Wellenkontaktkreises interpretierbare Transferfunktion Z_{W}(jω) = U_{W}(jω)/I_{W}(jω) ermittelt wird, welche den Zusammenhang zwischen den Spektren der Wellenspannung (U_{W}) und des zugehörigen Wellenstroms (I_{W}) im Frequenzbereich beschreibt.

5. Verfahren nach Anspruch 4, **dadurch gekennzeichnet, dass** zur vereinfachten Ermittlung der Transferfunktion die Struktur eines resistiv-induktiven Tiefpasses 1. Ordnung zugrunde gelegt wird.

6. Verfahren nach Anspruch 4, **dadurch gekennzeichnet, dass** als Transferfunktion ein frequenzunabhängiger Proportionalitätsfaktor bestimmt wird, der den Zusammenhang zwischen den Spektren der Wellenspannung (U_{W}) und des zugehörigen Wellenstroms (I_{W}) im unteren Frequenzbereich der elektrodynamischen Maschine(12) beschreibt.

7. Verfahren nach Anspruch 6, **dadurch gekennzeichnet, dass** mittels des Proportionalitätsfaktors aus der gemessenen Wellenspannung (U_{W}) ein geschätzter Wellenstrom berechnet wird, dass der Effektivwert des so berechneten Wellenstromes bestimmt wird, und dass der bestimmte Effektivwert im Zuge der Überwachung des Wellenstromes einer Bewertung mittels vorgegebener Grenzwerte unterworfen wird.

8. Verfahren nach Anspruch 6 oder 7, **dadurch gekennzeichnet, dass** im Zuge der Überwachung des Wellenstromes der Proportionalitätsfaktor direkt einer Bewertung mittels vorgegebener Grenzwerte unterworfen wird.

9. Verfahren nach einem der Ansprüche 6 bis 8, **dadurch gekennzeichnet, dass** zur Bestimmung des Proportionalitätsfaktors die einzelnen Proportionalitätsfaktoren der ungradzahligen Harmonischen einer Grundfrequenz, insbesondere Netzfrequenz, der Wellenspannung und des Wellenstromes durch Division von Amplituden gleicher Ordnungszahl nach Massgabe der Gleichung Z_{W}(nω) = U_{W}(nω)/I_{W}(nω) bestimmt werden, und dass aus der Menge der einzelnen Proportionalitätsfaktoren {Z_{W}(nω)} durch Medianbildung oder Mittelwertbildung ein resultierender geschätzter Proportionalitätsfaktor gewonnen wird.

10. Verfahren nach Anspruch 9, **dadurch gekennzeichnet, dass** die einzelnen Proportionalitätsfaktoren bis zu einer vorgegebenen oberen Grenzfrequenz, insbesondere etwa 1000 Hz, bestimmt werden.

11. Verfahren nach Anspruch 9 oder 10, **dadurch gekennzeichnet, dass** die Phasenwinkel Φ_{Z} = Φ_{U}(nω)-Φ_{I}(nω) der einzelnen Proportionalitätsfaktoren ermittelt werden, und dass die Proportionalitätsfaktoren mit Phasenwinkeln, die von den nach einer einfachen Transferfunktion zu erwartenden Werten stark abweichen, vor der Medianbildung bzw. Mittelwertbildung ausgeschieden werden.

12. Verfahren nach einem der Anspruch 9, **dadurch gekennzeichnet, dass** zu einem Zeitpunkt, zu dem bekannt ist, dass die Welle (13) so isoliert wird, dass keine Wellenströme (I_{W}) fliessen, die Signale einer für die Wellenstrommessung vorgesehenen Messspule bzw. Rogowski-Spule (17) aufgenommen werden, dass mittels einer Spektralanalyse Spektrallinien ermittelt werden, die von störenden Feldern eingekoppelt werden, und dass die zu Frequenzen mit dominanten Stör-Amplitudenwerten gehörenden einzelnen Proportionalitätsfaktoren vor einer Medianbildung aus der Menge der einzelnen Proportionalitätsfaktoren {Z_{W}(nω)} ausgeschieden werden.

13. Verfahren nach Anspruch 4, **dadurch gekennzeichnet, dass** Spektren der Wellenspannung (U_{W}) bei verschiedenen Lastzuständen der elektrodynamischen Maschine (12) nur einmal oder mindestens einmal bei Inbetriebnahme eines Überwachungssystems, störungsfrei gemessen und die Werte abgespeichert werden, dass im Betrieb der elektrodynamischen Maschine (12) bestimmt wird, in welchem Lastzustand sich die elektrodynamische Maschine (12) momentan befindet, und dass dann ein diesem Lastzustand entsprechender Datensatz mit dem jeweils gültigen Spektrum aus einem internen Speicher ausgelesen wird.

## Claims

1. Method for monitoring the shaft current (I_{W}) and/or the insulation of the shaft (13) of electrodynamic machines (12) during operation, **characterized in that** the shaft voltage (U_{W}) and the associated shaft current (I_{W}) on the shaft (13) are measured, **in that** a relationship between the shaft voltage (U_{W}) and the associated shaft current (I_{W}) is determined from the measurement results for the shaft voltage (U_{W}) and the shaft current (I_{W}) for the electrodynamic machine (12), and **in that**, in order to monitor the shaft current (I_{W}) of the electrodynamic machine (12), the shaft voltage (U_{W}) is monitored and the shaft current (I_{W}) to be monitored is deduced from the monitored shaft voltage (U_{W}) on the basis of the determined relationship between the shaft voltage (U_{W}) and the associated shaft current (I_{W}).

2. Method according to Claim 1, **characterized in that** the shaft current (I_{W}) is measured inductively on the shaft (13).

3. Method according to Claim 2, **characterized in that** the shaft current (I_{W}) is measured by means of a Rogowski coil (17) arranged around the shaft (13).

4. Method according to one of Claims 1 to 3, **characterized in that** the frequency spectra of the shaft voltage (U_{W}) and of the associated shaft current (I_{W}) are measured, and **in that** a transfer function Z_{W}(jω) = U_{W}(jω)/I_{W}(jω), which can be interpreted as the impedance function of the shaft contact circuit, is determined as the relationship between the shaft voltage (U_{W}) and the associated shaft current (I_{W}), said transfer function describing the correlation between the spectra of the shaft voltage (U_{W}) and of the associated shaft current (I_{W}) in the frequency range.

5. Method according to Claim 4, **characterized in that** the structure of a resistive-inductive first-order lowpass filter is taken as the basis for simplified determination of the transfer function.

6. Method according to Claim 4, **characterized in that** a frequency-independent proportionality factor is determined as the transfer function, said frequency-independent proportionality factor describing the correlation between the spectra of the shaft voltage (U_{W}) and of the associated shaft current (I_{W}) in the lower frequency range of the electrodynamic machine (12).

7. Method according to Claim 6, **characterized in that** an estimated shaft current is calculated from the measured shaft voltage (U_{W}) by means of the proportionality factor, **in that** the root mean square value of the shaft current calculated in this way is determined, and **in that** the determined root mean square value is subjected to an evaluation by means of predetermined limit values in the course of monitoring the shaft current.

8. Method according to Claim 6 or 7, **characterized in that** the proportionality factor is directly subjected to an evaluation by means of predetermined limit values in the course of monitoring the shaft current.

9. Method according to one of Claims 6 to 8, **characterized in that**, in order to determine the proportionality factor, the individual proportionality factors of the odd-numbered harmonics of a fundamental frequency, in particular of the mains frequency, of the shaft voltage and of the shaft current are determined by dividing amplitudes of the same order according to the equation Z_{W}(nω) = U_{W}(nω)/I_{W}(nω), and **in that** a resultant estimated proportionality factor is obtained by forming the median value or forming the mean value from the set of individual proportionality factors {Z_{W}(nω)}.

10. Method according to Claim 9, **characterized in that** the individual proportionality factors are determined up to a predetermined upper cut-off frequency, in particular approximately 1000 Hz.

11. Method according to Claim 9 or 10, **characterized in that** the phase angles Φ_{Z} = Φ_{U}(nω)-Φ_{I}(nω) of the individual proportionality factors are determined, and **in that** the proportionality factors with phase angles that differ significantly from the values expected according to a simple transfer function are excluded before forming the median value or forming the mean value.

12. Method according to Claim 9, **characterized in that**, at a time at which it is known that the shaft (13) is insulated in such a way that no shaft currents (I_{W}) are flowing, the signals of a measurement coil or Rogowski coil (17) that is provided for the shaft current measurement are recorded, **in that** spectral lines that are injected from interference fields are determined by means of a spectral analysis, and **in that** the individual proportionality factors that are associated with frequencies having dominant interference amplitude values are excluded from the set of individual proportionality factors {Z_{W}(nω)} before forming the median value.

13. Method according to Claim 4, **characterized in that** spectra of the shaft voltage (U_{W}) are measured without interference at different load states of the electrodynamic machine (12) only once or at least once during start-up of a monitoring system and the values are stored, **in that**, during operation of the electrodynamic machine (12), the present load state of the electrodynamic machine (12) is determined, and **in that** a data record corresponding to said load state is then read, with the respectively applicable spectrum, from an internal memory.

## Revendications

1. Procédé pour la surveillance du courant d'arbre (I_{W}) et/ou de l'isolation de l'arbre (13) de machines électrodynamiques (2) pendant leur fonctionnement, **caractérisé en ce que** la tension d'arbre (U_{W}) et le courant d'arbre (I_{W}) associé sont mesurés sur l'arbre (13), **en ce qu'**une relation entre la tension d'arbre (U_{W}) et le courant d'arbre (I_{W}) associé est déterminée à partir des résultats de mesure de la tension d'arbre (U_{W}) et du courant d'arbre (I_{W}) de la machine électrodynamique (12), et **en ce que** la tension d'arbre (U_{W}) est surveillée pour la surveillance du courant d'arbre (I_{W}) de la machine électrodynamique (12) et le courant d'arbre (I_{W}) à surveiller est déduit de la tension d'arbre (U_{W}) surveillée sur la base de la relation déterminée entre la tension d'arbre (U_{W}) et le courant d'arbre (I_{W}).

2. Procédé selon la revendication 1, **caractérisé en ce que** le courant d'arbre (I_{W}) est mesuré par induction sur l'arbre (13).

3. Procédé selon la revendication 2, **caractérisé en ce que** le courant d'arbre (I_{W}) est mesuré au moyen d'une bobine de Rogowski (17) disposée autour de l'arbre (13).

4. Procédé selon l'une quelconque des revendications 1 à 3, **caractérisé en ce que** les spectres de fréquence de la tension d'arbre (U_{W}) et du courant d'arbre (I_{W}) associé sont mesurés et **en ce qu'**une fonction de transfert Z_{W}(jω) = U_{W}(jω)/I_{W}(jω) qui décrit la relation entre les spectres de la tension d'arbre (U_{W}) et du courant d'arbre (I_{W}) associé dans le domaine des fréquences et pouvant être interprétée en tant que fonction d'impédance du circuit de contact d'arbre est déterminée en tant que relation entre la tension d'arbre (U_{W}) et le courant d'arbre (I_{W}) associé.

5. Procédé selon la revendication 4, caractérisé e ce que, pour déterminer de manière simplifiée la fonction de transfert, on se fonde sur la structure d'un filtre passe-bas à résistance-induction d'ordre 1.

6. Procédé selon la revendication 4, **caractérisé en ce qu'**un facteur de proportionnalité indépendant de la fréquence, qui décrit la relation entre les spectres de la tension d'arbre (U_{W}) et le courant d'arbre (I_{W}) associé dans le domaine des basses fréquences de la machine électrodynamique (12), est déterminé en tant que fonction de transfert.

7. Procédé selon la revendication 6, **caractérisé en ce qu'**un courant d'arbre estimé est calculé au moyen du facteur de proportionnalité à partir de la tension d'arbre (U_{W}) mesurée, **en ce que** la valeur effective du courant d'arbre ainsi calculé est déterminée, et **en ce que** la valeur effective déterminée est soumise à une évaluation au moyen de valeurs limites prédéterminées au cours de la surveillance du courant d'arbre.

8. Procédé selon la revendication 6 ou 7, **caractérisé en ce que** le facteur de proportionnalité est directement soumis à une évaluation au moyen de valeurs limites prédéterminées au cours de la surveillance du courant d'arbre.

9. Procédé selon l'une quelconque des revendications 6 à 8, **caractérisé en ce que** les facteurs de proportionnalité individuels des harmoniques impairs d'une fréquence fondamentale, notamment de la fréquence du secteur, de la tension d'arbre et du courant d'arbre sont déterminés pour déterminer le facteur de proportionnalité, par division d'amplitudes de même numéro d'ordre après détermination de l'équation Z_{W}(jω) = U_{W}(nω)/I_{W}(nω), et **en ce qu'**un facteur de proportionnalité estimé résultant est obtenu à partir de l'ensemble des facteurs de proportionnalité individuels {Z_{W}(nω)} par calcul de médiane ou par calcul de valeur moyenne.

10. Procédé selon la revendication 9, **caractérisé en ce que** les facteurs de proportionnalité individuels sont déterminés jusqu'à une fréquence limite supérieure prédéterminée, notamment d'environ 1000 Hz.

11. Procédé selon la revendication 9 ou 10, **caractérisé en ce que** les angles de phase Φ_{Z} = Φ_{U}(nω)-Φ_{I}(nω) des facteurs de proportionnalité individuels sont déterminés, et **en ce que** les facteurs de proportionnalité dont les angles de phase s'écartent fortement des valeurs attendues conformément à une fonction de transfert simple, sont exclus avant le calcul de médiane ou le calcul de valeur moyenne.

12. Procédé selon la revendication 9, **caractérisé en ce qu'**à un instant lors duquel il est connu que l'arbre (13) est isolé de telle manière qu'aucun courant d'arbre (I_{W}) ne passe, les signaux d'une bobine de mesure ou d'une bobine de Rogowski (17) prévue pour la mesure du courant d'arbre, sont acquis, **en ce que** des raies spectrales qui sont couplées en entrée par des champs perturbateurs sont déterminées au moyen d'une analyse spectrale, et **en ce que** les facteurs de proportionnalité individuels appartenant à des fréquences ayant des valeurs d'amplitude parasites dominantes sont exclus avant le calcul de médiane de l'ensemble des facteurs de proportionnalité individuels {Z_{W}(nω)}.

13. Procédé selon la revendication 4, **caractérisé en ce que** des spectres de la tension d'arbre (U_{W}) sont mesurés sans perturbation une seule fois ou au moins une fois pour différents états de charge de la machine électrodynamique (12) lors de la mise en fonctionnement d'un système de surveillance, **en ce que**, lors du fonctionnement de la machine électrodynamique (12), l'état de charge dans lequel se trouve à un instant donné la machine électrodynamique (12) est déterminé, et **en ce qu'**un ensemble de données correspondant audit état de charge, et ayant un spectre valide associé, est lu à partir d'une mémoire interne.
